# EUROPEAN PATENT APPLICATION

(11) **EP 4 565 013 A2**
(43) Date of publication of application: **04.06.2025**
(21) Application number: 24207716.2
(22) Date of filing: 21.10.2024
(51) Int. Cl.: H05K 1/02, H05K 1/14

(54) **DELIVERY OF POWER TO A CHIP THROUGH A DAUGHTER BOARD USING CONNECTIVE ELECTRICAL COMPONENTS**

(30) Priority: 30.11.2023 US 202318525713
(71) Applicant: Arista Networks, Inc., Santa Clara, CA 95054 (US)
(72) Inventor: WILCOX, Robert Morris, Santa Clara, CA 95054 (US); PARK, Youngbae, Santa Clara, CA 95054 (US); THOMPSON, Samuel, Santa Clara, CA 95054 (US)
(74) Representative: Hoffmann Eitle

(57) **Abstract**

Systems and methods for using a daughter board to deliver power from the power supply to a chip on a host board, where power is converted to a desired voltage (e.g., from a higher voltage to a lower voltage), provided to a daughter board, processed as needed on the daughter board, and delivered to the host board at locations close to the chip. The power is delivered from the daughter board to the host board through connective electrical components which may comprise decoupling capacitors that are soldered between the boards to provide minimized transient response characteristics as well as structural support between the boards, or coaxial connectors that provide reduced inductance and are secured between the boards by structural posts.

## Description

### TECHNICAL FIELD

The disclosed embodiments relate generally to providing power to chips on printed circuit boards, and more particularly to systems and methods for routing converted power through a daughter board to deliver the power in close proximity to a chip on a host board using connective electrical components between the boards.

### BACKGROUND

Some electrical devices such as network switches are constructed using a host board (e.g., a printed circuit board, or PCB) on which a number of electrical components are mounted. These components may include many different types of components which may range from simpler components such as resistors, capacitors, and inductors, to somewhat more complex components such as transistors, diodes, switches, and the like, or very complex data processing components such as integrated circuits (ICs), Application-Specific Integrated Circuits (ASICs), Field-Programmable Gate Arrays (FPGAs), or the like. These components are interconnected by conductive traces and conductive layers in the host board.

Commonly, in addition to the other electrical components, the host board has a power supply that provides electrical power to the components on the host board. Often, the power is provided through a conductive (e.g., metallic) layer of the host board. The power provided by the power supply to the electrical components may need to be converted or conditioned before being provided to the components on the host board. For example, the host board typically receives the main power at a first voltage (e.g., 5V, 12V or 48V) and converts it using a DC-DC converter or power converter module to a lower voltage (e.g., 0.7V) which is required by an ASIC or FPGA. The current is then delivered to the ASIC or FPGA by the copper layer of the host board.

For a large ASIC or FPGA, it can be challenging to design the host board to deliver the necessary electrical power because of the large amount of current that is required. The design of the host board is also complicated and made even more challenging by the need to include power processing circuitry which is necessary to meet the transient response requirement of the ASIC or FPGA. As the power requirement increases, various problems arise in the host board design, such as a lack of board space for growing power converter components, the voltage drop across the copper layer through which the power is provided to the ASIC or FPGA, and deteriorated transient response in the power provided to the ASIC or FPGA.

### BRIEF DESCRIPTION OF THE DRAWINGS

The drawings accompanying and forming part of this specification are included to depict certain aspects of the disclosure. It should be noted that the features illustrated in the drawings are not necessarily drawn to scale. A more complete understanding of the disclosure and the advantages thereof may be acquired by referring to the following description, taken in conjunction with the accompanying drawings in which like reference numbers indicate like features.
FIG. 1 is a diagram that is shown to illustrate the arrangement of a chip and a power converter on a host board in accordance with the prior art.
FIG. 2 is a diagram that is provided to illustrate the internal structure of a host board and the transmission of power from a power converter to a chip on the host board in accordance with the prior art.
FIGS. 3A and 3B are a pair of diagrams that are provided to illustrate the use of a daughter board to convey power from a power converter to a chip in accordance with some embodiments.
FIGS. 4A and 4B are a pair of diagrams that are shown to illustrate the structure of a decoupling capacitor and installation of the decoupling capacitor as a connective electrical component between a host board and a daughter board in accordance with some embodiments.
FIGS. 5A and 5B are a pair of diagrams that are shown to illustrate the structure of a coaxial connector and installation of the coaxial connector as a connective electrical component between a host board and a daughter board in accordance with some embodiments.
FIGS. 6A-6D are a set of figures that are shown to illustrate the assembly of a daughter board and host board using decoupling capacitors in accordance with some embodiments.
FIG. 7 is a diagram that is shown to illustrate the final assembly of the daughter board and host board using coaxial connectors in accordance with some embodiments.
FIG. 8 is a diagram illustrating a coaxial connector and a corresponding mounting location on a boards in accordance with some embodiments.

### DETAILED DESCRIPTION

Embodiments and the various features and advantageous details thereof are explained more fully with reference to the non-limiting embodiments that are illustrated in the accompanying drawings and detailed in the following description. Descriptions of well-known starting materials, processing techniques, components and equipment are omitted so as not to unnecessarily obscure the embodiments in detail. It should be understood, however, that the detailed description and the specific examples are given by way of illustration only and not by way of limitation. Various substitutions, modifications, additions and/or rearrangements within the spirit and/or scope of the underlying inventive concept will become apparent to those skilled in the art from this disclosure.

Embodiments disclosed herein address the problems discussed above by using a daughter board to deliver power from the power supply to the ASIC. For the sake of brevity and clarity, "chip" is used here, and will be used throughout the remainder of this disclosure to refer to an IC, ASIC, FPGA, or any other data processing component that has power requirements similar to such components. The daughter board is a second board which is mounted to the underside of the host board, and more specifically is mounted underneath the position of the chip on the host board. The daughter board receives power from the power supply and provides the power required by the chip to the host board at or near the point(s) at which the power is actually drawn by the chip.

This allows the power supply to be moved to less valuable real estate on the host board, or can even eliminate the use of space on the host board for the power supply (by moving associated components to the daughter board). In either case, the provided power is converted to the desired voltage (e.g., from a higher voltage to a lower voltage) and is processed as needed on the daughter board, after which it is delivered to the host board at locations close to the chip (e.g., near the pad locations of the chip).

The power from the daughter board is conveyed to the host board via electrical connectors between the two boards. The electrical connectors can include decoupling capacitors, coaxial power connectors, and conductive spacers (collectively "connective electrical components"), each of which is electrically connected between the host board and the daughter board. Each of the different types of connective electrical components may provide structural support between the daughter board and the host board, as well as carrying electrical current between them.

Decoupling capacitors may be used to provide a current loop between the host board and the daughter board (through the end caps of the capacitors) that minimizes transient response characteristics. The coaxial power connectors provide a current path between the daughter board and the host board which has a lower inductance than a simple solid conductor. At some regions of the host board, it may be less important to minimize the transient response characteristics and/or inductance of the current supplied to the host board (e.g., at locations which provide power to non-chip components on the host board), so simple conductive spacers may be used to carry the current at these locations.

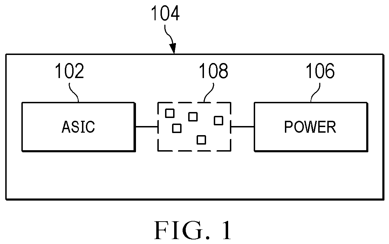

Before discussing the disclosed embodiments in detail, it may be helpful to describe the general structure of a host board and the arrangement of some of the components on the host board. Referring to FIG. 1, a diagram is shown to illustrate the arrangement of a chip and a power converter on a host board in accordance with the prior art. In this example, a chip 102 is positioned generally in the center of host board 104. A power converter 106 is positioned near the edge of host board 104. The power converter is typically positioned closer to the edge of the board than to the chip because the space closer to the chip is considered more "valuable" and is used for components that provide some of the functionality of the board or support the functionality of the chip.

Power converter 106 typically receives power from an off-board power source and converts the power from a higher voltage (e.g., 5 volts, 12 volts or 48 volts) to a lower voltage (e.g., 0.7 volts) which is suitable for the chip and/or for other components on the host board. Before the power from the power converter 106 is consumed by the chip 102, various components 108 (which are typically passive components) may regulate the power.

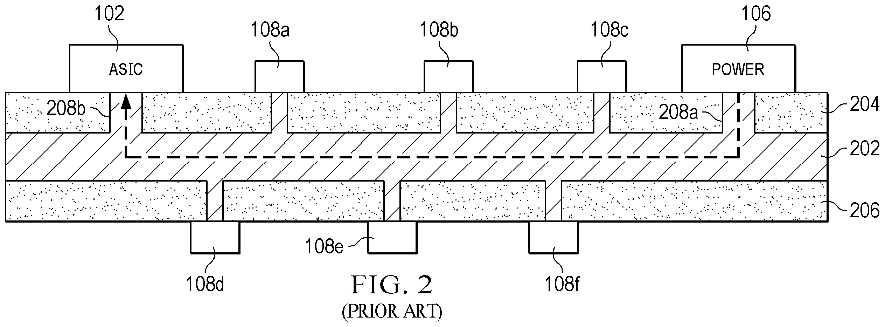

Referring to FIG. 2, a diagram is provided to illustrate the internal structure of host board 104 and the transmission of power from power converter 106 to chip 102. As depicted in this figure, host board 104 has a central electrically conductive layer 202 which is sandwiched between insulating layers 204 and 206. These layers are shown to illustrate the general structure of the host board, and it should be noted that there may be additional conductive layers and/or insulating layers. It should also be noted that the electrically conductive layers may have separate, electrically isolated sections that are used for different purposes (e.g., a first section may provide power at a first voltage, a second section may provide power at a second voltage, and a third section may provide an electrical ground).

As shown in FIG. 2, components mounted on the surface of host board 104 are electrically connected to conductive layer 202 by electrically conductive vias that extend through insulating layers 204 and 206. For example, power converter 106 is connected to electrically conductive layer 202 through via 208a. Similarly, chip 102 is connected to electrically conductive layer 202 through via 208b. Power can therefore be conveyed from power converter 106 to chip 102 through via 208a, conductive layer 202 and via 208b.

Electrical connections between board components 108a-108f are likewise made through corresponding vias. It should be noted that the individual components need not all be connected to electrically conductive layer 202. The components may be connected through vias to different sections of the conductive layer, or to different conductive layers. Some components may not need to be connected to conductive layers within the host board, but may instead be interconnected with other components by electrical traces on the surfaces of the host board.

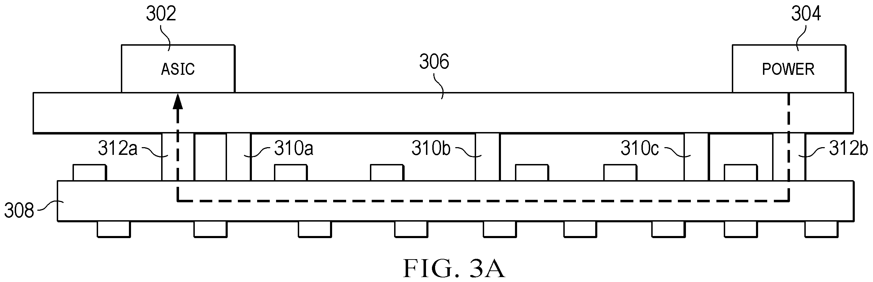

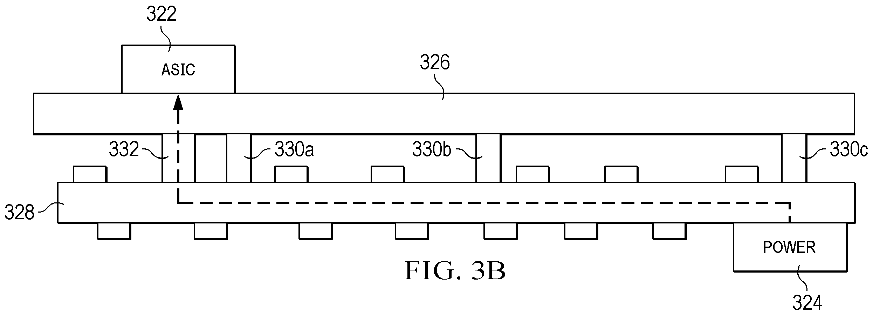

Referring to FIGS. 3A and 3B, a pair of diagrams are provided to illustrate the use of a daughter board to convey power from a power converter to a chip in accordance with some embodiments. Referring to FIG. 3A, a chip 302 and a power converter 304 are both mounted on a host board 306. In this example, power is not conveyed from power converter 304 to chip 302 through host board 306. Instead, power is conveyed through a daughter board 308.

Daughter board 308 is mounted to the underside of host board 306. Daughter board 308 is secured to host board 306 using one or more connective components that maintain a desired spacing between the two boards. The spacing between daughter board 308 and host board 306 allows room for electrical components to be mounted on the upper side of daughter board 308 or the underside of host board 306 without interfering with each other. The space between daughter board 308 and host board 306 may also allow for ventilation between the boards which improves cooling of components that are positioned on the facing sides of the boards.

The connective components that secure daughter board 308 to host board 306 may include components that are purely structural, as well as components that are both structural and electrically conductive. There may also be connective components that are electrical, but provide no structural support between the daughter board and host board.

In the example of FIG. 3A, both structural-only components 310 and electrically conductive components 312 are used to secure daughter board 308 and host board 306 to each other. In particular, connective electrical components 312a and 312b are positioned near chip 302 and power converter 304, respectively. Connective electrical component 312b is used to convey power from power converter 304, which is mounted on host board 306, to the electrically conductive layer of daughter board 308. The power is conveyed through daughterboard 308 to connective electrical component 312a, which carries the power from the daughter board to chip 302, which is mounted on host board 306.

Referring to FIG. 3B, a second example is provided in which power is conveyed from a power converter 324 to a chip 322 through a daughter board 328. This example is very similar to the example of FIG. 3A, but the power converter is mounted on daughter board 328 instead of host board 326. Thus, power from power converter 324 is provided to an electrically conductive layer of daughter board 328, which carries the power to connective electrical component 332. The power is then conveyed through connective electrical component 332 to chip 322.

Like the example of FIG. 3A, the embodiment of FIG. 3B may include connective components that are purely structural, connective components that are both structural and electrically conductive, and connective components that are electrical but not structural. In this example, at least connective component 332 is capable of conveying power from daughter board 328 to host board 326. Connective components 330a-330c in this example are structural, although they could also connect the two boards electrically.

The connective electrical components that are used to carry power between the daughter boards and host boards may be of several different types. The most simple of the connective electrical components is a conductive post or spacer. The conductive post or spacer (e.g., a solid copper spacer) may be soldered to corresponding electrical contacts on the daughter board and host board. This will provide structural support between the two boards, as well as allowing current to flow through the spacer from one board to another. One of the problems with using a simple conductive spacer for this purpose is that these spacers typically have high inductance, so it may be necessary to incorporate additional circuitry into the designs of the daughter board, host board, or both to compensate for the inductance.

An alternative type of connective electrical component is a decoupling capacitor, where each end cap of the capacitor is soldered to the daughter board and the host board in a manner similar to the soldering of the conductive spacer between the boards. Each capacitor end cap thereby provides both structural support between the daughter board and the host board, and a conductive path between the two boards. The use of a decoupling capacitor, however, differs from the use of a conductive spacer in that the capacitor provides a forward current path between the boards through one of the end caps and a return current path through the other end cap. The capacitance provided between the two current paths, which minimizes the transient response characteristics of the power provided to the chip.

Another alternative type of connective electrical component is a coaxial connector. The coaxial connector includes an inner conductive ring and an outer conductive ring. The rings may, for example, be made of copper. Electrically insulating rings are provided between the conductive rings, as well as exterior to the outer conductive ring and interior to the inner conductive ring. The conductive rings provide electrically conducting paths between the daughter board and the host board, where the coaxial connector provides low inductance in the conducting paths. The conductive rings are positioned in contact with conductive pads on the daughter board and host board, and a post which is placed through the inner insulating ring provides a means to secure the conductive rings against the conductive pads, as well as securing the daughter board against the host board. The post may, for example, be made of steel.

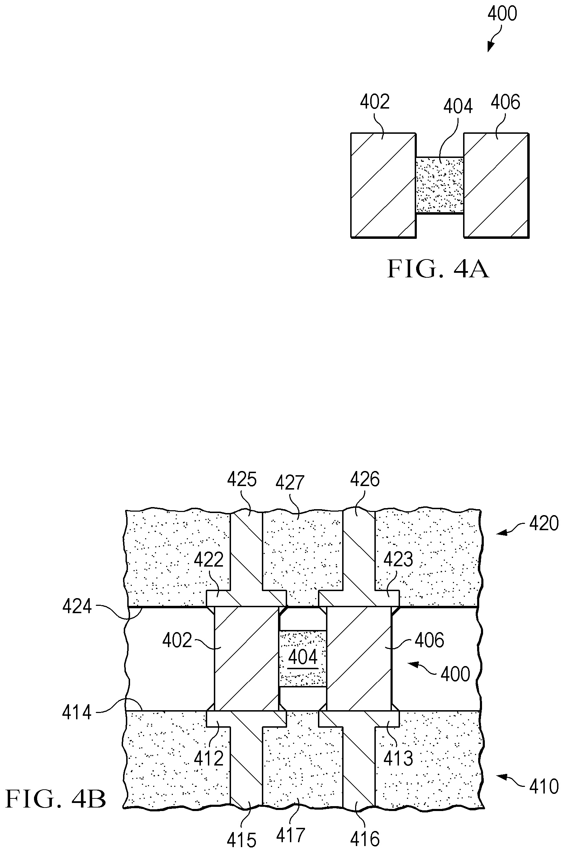

Referring to FIGS. 4A and 4B, a pair of diagrams are shown to illustrate the structure of a decoupling capacitor and installation of the decoupling capacitor as a connective electrical component between a host board and a daughter board.

Referring to FIG. 4A, a decoupling capacitor is shown. The decoupling capacitor 400 in this example comprises a pair of metal end caps 402 and 406 and an insulator 404 which is positioned between the end caps. The decoupling capacitor provides a capacitance between the end caps and, when installed as a connective electrical component between a daughter board and a host board, will provide the capacitance between the forward current path and return current path between the boards.

It should be noted that, while the structure of the decoupling capacitor in this example is very simple, other types of capacitors having more complex structures may be used in other embodiments. These structures may, for example, have one or more positive and negative plates separated by insulators, where the positive plates are connected to a first terminal and the negative plates are connected to a second terminal. The terminals comprise electrically conductive structures that can be connected to a daughter board and a host board in the same manner as the end caps of decoupling capacitor 400 as described in more detail below.

Referring to FIG. 4B, the decoupling capacitor 400 of FIG. 4A is shown mounted between a daughter board 410 and a host board 420. Daughter board 410 has a pair of electrical contact pads 412 and 413 which are exposed at the upper surface 414 of the board. Each of pads 412 and 413 is connected to a corresponding electrically conductive via, 415 and 416. The contact pads and vias are embedded in an electrically insulating material 417 which forms the body of daughter board 410. Similarly, host board 420 has a pair of electrical contact pads 422 and 423 which are exposed at the lower surface 424 of the host board. Each of contact pads 422 and 423 is connected to a corresponding electrically conductive via, 425 and 426. The contact pads and vias of host board 420 are embedded in an electrically insulating material 427 which forms the body of the host board.

It can be seen in the figure that each of the end caps of decoupling capacitor 400 is positioned in contact with corresponding contact pads on daughter board 410 and host board 420. End cap 402 is in contact with pad 412 of daughter board 410 and pad 422 of host board 420. The top and bottom of end cap 402 are soldered to the contact pads to form a first electrical path between the daughter board and the host board. Similarly, the upper and lower ends of end cap 406 are soldered to contact pads 423 of the host board and 413 of the daughter board, respectively, to form a second electrical path between the daughter board and the host board.

These electrical paths effectively form a loop for current to flow between the daughter board and the host board (forward current flows through a first one of the electrical paths, and return current flows through the other of the electrical paths). Insulator 404 provides capacitance between the two electrical paths. This arrangement minimizes the transient response characteristics of the power provided through these electrical paths. The decoupling capacitor is soldered between the daughter board and host board in close proximity to the chip so that the power provided to the chip will have the benefit of the reduced transient response characteristics.

In addition to minimizing the transient response characteristics of the power provided to the chip, the soldered end caps of the decoupling capacitor provide structural support between the daughter board and the host board. In other words, the decoupling capacitor maintains spacing between the boards and also helps to secure the boards to each other.

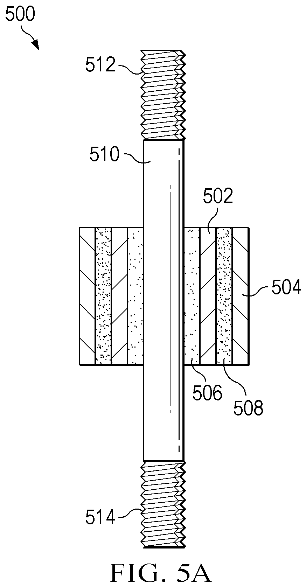

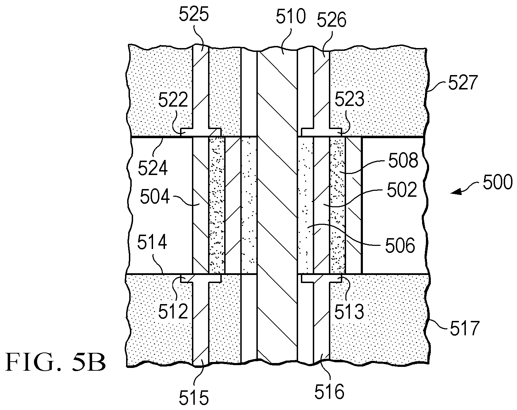

Referring to FIGS. 5A and 5B, a pair of diagrams are shown to illustrate the structure of a coaxial connector and installation of the coaxial connector as a connective electrical component between a host board and a daughter board.

Referring to FIG. 5A, a coaxial connector is shown. The coaxial connector 500 in this example comprises a pair of electrically conductive rings 502 and 504 which are separated by an insulating ring 508. The rings are all coaxially positioned with a central post 510 extending along the axis of the connector. A second insulating ring 506 is positioned between inner conductive ring 502 and post 510.

When installed as a connective electrical component between a daughter board and a host board, the coaxial connector provides two conductive paths between the daughter board and the host board. One of the conductive paths allows forward current to be conveyed from the daughter board to the host board, while the other conductive path allows return current from the host board to the daughter board. The coaxial arrangement of the conductive rings reduces the inductance of the current paths.

Central post 510 provides a means to secure the daughter board to the host board. The central post extends through the daughter board and the host board, as well as backing plates, heat sinks or similar structural components, and nuts are secured to the threaded ends 512 and 514 of the post to hold the boards, backing plates, etc., together. Central post 510 typically does not make electrical contact with the conductive rings, daughter board, host board, or components on the boards, and is not normally used to carry current between the boards, although some alternative embodiments may use the post for this purpose.

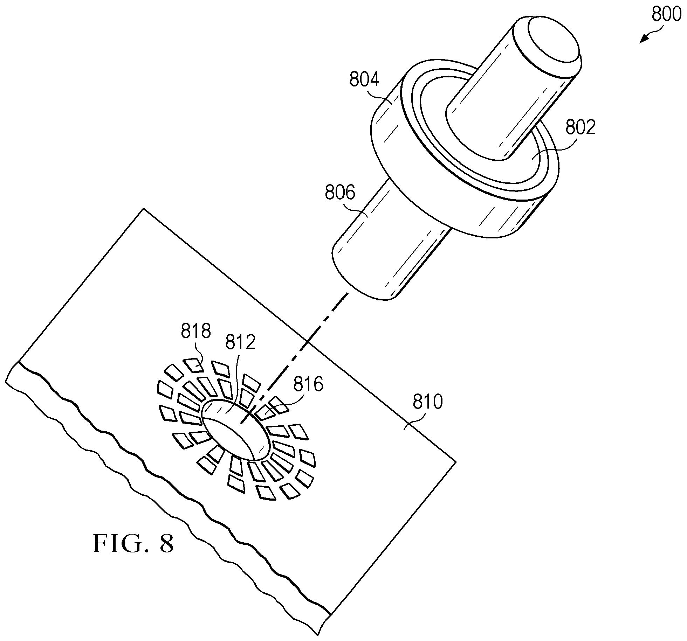

Referring to FIG. 5B, the coaxial connector 500 of FIG. 5A is shown mounted between a daughter board 517 and a host board 527. Daughter board 517 has a pair of electrical contact pads 512 and 513 which are exposed at the surface upper surface 514 of the board. Although not shown in the figure, each of contact pads 512 and 513 is one of a corresponding set of contact pads that are circularly arranged to contact the respective conductive rings of the coaxial connector (as shown in more detail in FIG. 8). Each pad in the set corresponding to contact pad 512 is configured in substantially the same manner as contact pad 512, and each pad in the set corresponding to contact pad 513 is configured in substantially the same manner as contact pad 513. A perspective view of the sets of contact pads is shown in Fig. 8, where contact pad 513 is part of the inner set of contact pads including 816, while contact pad 512 is part of the outer set of contact pads including 818.

Each of pads 512 and 513 is connected to a corresponding electrically conductive via. Contact pad 512 is connected to via 515, and contact pad 513 is connected to via 516. The contact pads and vias are embedded in an electrically insulating material which forms the body of daughter board 517.

Host board 527 is configured in a manner similar to daughter board 517. Host board 527 has a pair of electrical contact pads 522 and 523 which are exposed at the lower surface 524 of the host board, and each of the contact pads is connected to a corresponding electrically conductive via. Contact pad 522 is connected to via 525, and contact pad 523 is connected to via 526. The contact pads and vias of host board 527 are embedded in an electrically insulating material which forms the body of the host board.

Coaxial connector 500 is positioned so that conductive rings 502 and 506 are in contact with contact pads 513 and 512, respectively, on daughter board 517 and contact pads 523 and 522, respectively, on host board 527. Conductive rings 502 and 506 are also in contact with the contact pads in the circularly arranged sets of contact pads corresponding to contact pads 512, 513, 522 and 523.

Conductive rings 502 and 506 thereby form two sets of electrical paths between the daughter board and the host board. The first electrical path extends from via 516 and contact pad 513 through conductive ring 502 to contact pad 523 and via 526. The second electrical path extends from via 515 and contact pad 512 through conductive ring 506 to contact pad 522 and via 525. These electrical paths form a loop for current to flow between the daughter board and the host board (forward current flows through a first one of the electrical paths, and return current flows through the other of the electrical paths). Coaxial connector provides reduced inductance between the daughter board and the host board.

In addition to reducing the inductance between the boards, the coaxial connector provides structural support between the daughter board and the host board. When each of the conductive rings is held between the boards, the rings serve as spacers. Central post 510 extends through the conductive rings of the connector and also extends through holes in the daughter board and host board so that the ends of the post can be secured with threaded nuts. As noted above, the post typically also extends through backing plates or similar structures which hold the daughter board and host board securely in contact with the conductive rings of the coaxial connector.

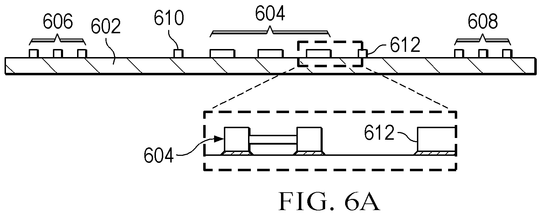

Referring to FIGS. 6A-6D, a set of figures are shown to illustrate the assembly of a daughter board and host board using decoupling capacitors in accordance with some embodiments. Referring to FIG. 6A, a daughterboard 602 has decoupling capacitors and copper spacers mounted on one side. Decoupling capacitors 604 are mounted near the center of daughter board 602. These decoupling capacitors will be in close proximity to a chip when the daughterboard is secured to a host board on which the chip is mounted. The detail in FIG. 6A shows that the end caps of the decoupling capacitors are soldered to daughter board 602 as discussed above.

A first set of copper spacers 606 is mounted on one end of daughter board 602 and a second set of copper spacers 608 is mounted on the opposite end of the board. Copper spacers 606 and 608 will be closer to corresponding power converters on the host board when the daughter board and host board are secured to each other. Additional copper spacers (e.g., 610 and 612) may be mounted at other positions on the daughterboard. All of the copper spacers are soldered to daughter board 602 as shown in the detail of the figure.

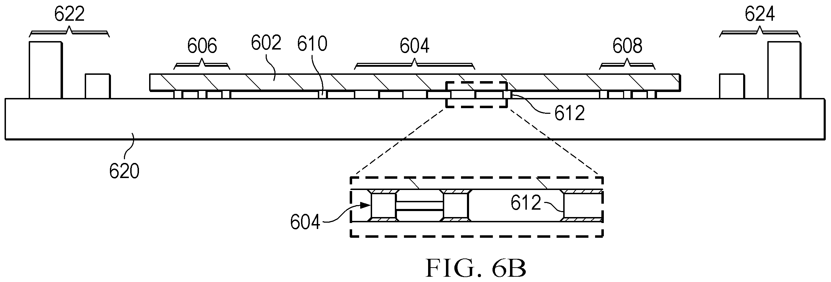

Referring to FIG. 6B, daughterboard 602 is shown mounted to host board 620. Host board 620 has components corresponding to a first power converter 622 mounted on one end of the board and components corresponding to a second power converter 624 mounted on the opposite end of the host board. Daughter board 602 is positioned with the spacers and decoupling capacitors facing host board 620. Both the copper spacers and the end caps of the decoupling capacitors are soldered to host board 620, thereby securing daughter board 602 to the host board. The soldered ends of one of the copper spacers and one of the decoupling capacitors are shown in the detail of the figure.

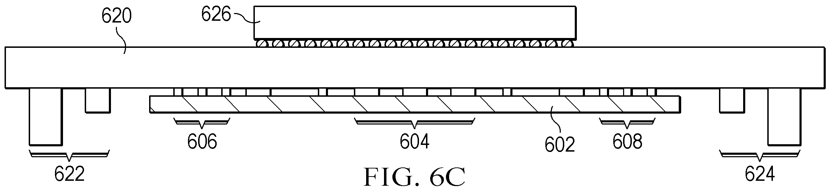

Referring to FIG. 6C, host board 620 is shown with a chip mounted to the board opposite the decoupling capacitors. More specifically, the decoupling capacitors are positioned in close proximity to the mounting pads of the chip through which power is provided to the chip.

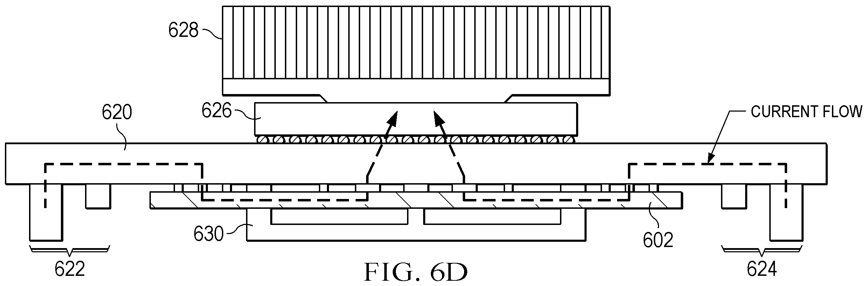

Referring to FIG. 6D, the completed assembly is shown. In this assembly, a heat sink 628 is mounted on top of chip 626 to dissipate heat generated by the chip. A backing plate 630 is mounted against daughter board 602. Backing plate 630 may be secured against daughter board 602 by, for example, installing screws or posts through the backing plate, daughter board 602, host board 620 and heat sink 628 to hold the backing plate to the heat sink and thereby secure the intervening components (i.e., the daughter board and the host board) to each other.

FIG. 6D shows the manner in which the daughter board is used to provide power to the chip on the host board. In this example, power is provided from an off-board source to the power converter components (622, 624) on the host board. The route through which the power is provided from the power converters to the chip is shown generally by the arrows in the figure.

The off-board power may be provided to the power converter components at, for example, 12V. The power converter components convert the power to a voltage (e.g., 0.7V) required by the on-board components such as the chip. The power output by the power converter components is conveyed through a conductive metal layer of the host board to the set of copper spacers at the outer edges of the daughter board. The copper spacers carry the power from the host board to the daughter board. The power may be provided to one or more power processing components on the daughter board. The power processing components are not explicitly shown in the figure, but they may be mounted on either one side or both sides of the daughter board. The daughter board provides additional space for such power processing components (or potentially other types of components), and the ability to locate components on both sides of the daughter board roughly doubles the available space for these components.

The processed power is provided through the processing components and/or the metal layer of the daughter board to the central portion of the daughter board which is in proximity to the location of the chip on the host board. The power is then conveyed from the daughter board to the host board via the end caps of the decoupling capacitors. As noted above, the decoupling capacitors are positioned at or near the locations of the contact pads for the chip through which power is drawn by the chip. Since the power is routed through the daughter board to these locations on the host board, the design of the host board is simplified (it does not need to include processing components or routing elements to convey the power from the power converters to the chip).

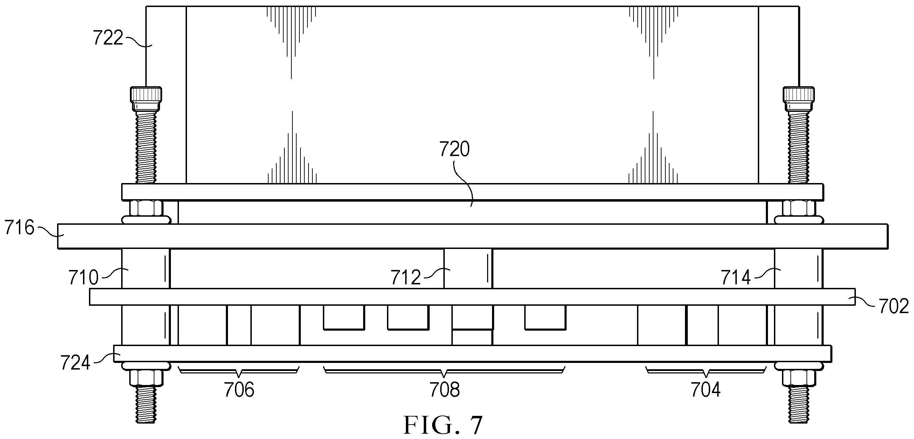

Referring to FIG. 7, a diagram is shown to illustrate the final assembly of the daughter board and host board using coaxial connectors in accordance with some embodiments. In this example, daughter board 702 is assembled with power converter components 704 and 706 on the board. As explained above, the power converter components could alternatively be mounted on the host board. Daughter board 702 may also include additional components 708 that may process the power output by the power converter components or perform various other functions. Although the figure depicts only components mounted on the underside of the daughter board (facing away from the host board), components may also be mounted on the upper side of the daughter board.

Host board 716 is also assembled with chip 720 mounted on an upper side of the board (the side facing away from the daughter board). FIG. 7 only shows the portion of host board 716 close to chip 720, but the host board typically has a greater extent (e.g., to the right and left sides of the figure) and has additional components mounted thereon. The full extent of host board 716 is not included in the figure for purposes of clarity.

Coaxial connectors 710, 712, 714 are then positioned between daughter board 702 and host board 716 with the posts of the coaxial connectors extending through the corresponding holes in the daughter board and host board. This causes the conductive rings of the coaxial connectors to be aligned with the corresponding electrical contact pads on the boards.

Referring to FIG. 8, one of the coaxial connectors and the corresponding mounting location on one of the boards is shown in more detail. In this figure, it can be seen that the inner (802) and outer (804) conductive rings of coaxial connector 800 are positioned roughly midway along the length of coaxial post 806. It can also be seen that an inner set (e.g., 816) and outer set (e.g., 818) of conductive contact pads are coaxially arranged around a hole 812 in board 810. When post 806 is inserted through hole 812, inner ring 802 of coaxial connector 800 is guided into contact with the inner ring of contact pads (including 816) and outer ring 804 of the coaxial connector is guided into contact with the outer ring of contact pads (including 818).

Referring again to FIG. 7, the posts of the coaxial connectors extend upward through host board 716 and nuts are threaded onto the posts to secure the connectors against the host board. Heat sink 722, which has holes corresponding to the positions of the coaxial connector posts, is positioned over the posts and against chip 720, and is secured to the posts. The other ends of the coaxial connectors extend downward through corresponding holes in daughter board 702, as well as through backing plate 724, and nuts are threaded onto the posts to secure the assembly, with the host board and daughter board being pressed into contact with the coaxial connectors. The pressure of the conductive rings against the contact pads may partially deform the contact pads, ensuring good contact with the conductive rings.

The assembly of FIG. 7 enables power to be provided from power converters 704 and 706 through a conductive metal layer of daughter board 702 to the coaxial connectors 710, 712, 714. Power is then carried via coaxial connectors 710, 712, 714 from daughter board 702 to host board 716. Coaxial connectors 710, 712, 714 are positioned in proximity to chip 720 so that power can be conveyed to the ASIC with low impedance.

While embodiments described herein have been described with respect to a limited number of embodiments, those skilled in the art, having the benefit of this detailed description, will appreciate that other embodiments can be devised which do not depart from the scope of embodiments as disclosed herein. Examples of some alternative embodiments are provided below.

One embodiment comprises an apparatus having a host board with a chip mounted on a first side of the board. A daughter board is mounted on a second, opposing side of the host board, where a set of connective electrical components are connected between the daughter board and the host board at locations which are proximal to a location of the chip. A power converter provides power to the daughter board, and the daughter board delivers power to the chip via the connective electrical components.

In some embodiments, the connective electrical components comprise capacitors. Each capacitor comprises an insulator between two conductive end caps and, for each capacitor, each end cap is soldered to a corresponding conductive element (e.g., trace) on the daughter board and a corresponding conductive element (e.g., trace) on the host board. In some embodiments, the connective electrical components comprise coaxial conductors. Each coaxial conductor comprises an outer conductive ring and an inner conductive ring which are separated by a first insulating ring. Each coaxial conductor may further comprise a structural post. The structural post may be electrically conductive and a second insulating ring may be positioned between the structural post and the inner conductive ring.

In some embodiments, the apparatus may further comprise a heat sink and a backing plate, where the heat sink is positioned in contact with a side of the chip opposite the host board and the backing plate is positioned on a side of the daughter board opposite the host board, and where the structural posts secure the heat sink to the backing plate and thereby hold the heat sink in contact with the chip and hold the coaxial spacers in position between the daughter board and the host board.

In some embodiments, the apparatus further comprises, for each coaxial conductor, corresponding sets of contact pads on the host board and the daughter board, wherein each of the sets of contact pads is electrically connected to an electrical component of either the host board or the daughter board, wherein each of the contact pads in the first set is positioned to contact either the outer conductive ring or the inner conductive ring of the coaxial conductor when the coaxial conductor is mounted between the daughter board and the host board.

In some embodiments, the apparatus further comprises spacers that are positioned between the daughter board and the host board, the spacers maintaining structural spacing between the daughter board and the host board. The spacers may comprise conductive material, where each of the spacers carries current between the daughter board and the host board.

The power converter may be mounted on either the daughter board or the host board. In some embodiments, the power converter is mounted on the host board at a position which is in a peripheral region of the host board, and power from the power converter is routed from the peripheral region of the host board to the daughter board and then routed from the daughter board to the host board via the connective electrical components proximal to the location of the chip. The daughter board may have power processing components mounted on two opposing sides of the board.

An alternative embodiment comprises a method for providing power to a chip mounted on a host board. The method includes mounting a chip on a first side of a host board and mounting a daughter board on a second side of the host board opposite the first side of the board, where a set of connective electrical components are connected between the daughter board and the host board at locations which are proximal to the location of the chip. Power is then provided from a power converter to the daughter board and the power is conveyed through the daughter board to the connective electrical components, and through the connective electrical components to the chip.

In some embodiments, the connective electrical components comprise decoupling capacitors, and the method further comprises, for each decoupling capacitor, soldering each end cap of the decoupling capacitor to corresponding electrical connections of the daughter board and the host board to form a corresponding electrical path between the daughter board and the host board. In other embodiments, the connective electrical components comprise coaxial conductors and the method comprises, for each coaxial conductor, securing the coaxial conductor between the daughter board and the host board, wherein a first conductive ring of the coaxial conductor forms a first electrical path between the daughter board and the host board and a second conductive ring of the coaxial conductor forms a second electrical path between the daughter board and the host board.

In some embodiments the power converter is mounted on the daughter board, while in others, the power converter is mounted on the host board, in which case the method further comprises conveying the power from the host board to the daughter board prior to conveying the power through the daughter board to the connective electrical components. In some embodiments, the daughter board has power processing components mounted thereon, and the method further comprises processing the power received from the power converter using the power processing components prior to conveying the power through the connective electrical components to the chip.

It will be understood that while specific embodiments have been presented herein, these embodiments are merely illustrative, and not restrictive. Rather, the description is intended to describe illustrative embodiments, features and functions in order to provide an understanding of the embodiments without limiting the disclosure to any particularly described embodiment, feature or function, including any such embodiment feature or function described. While specific embodiments of, and examples for, the embodiments are described herein for illustrative purposes only, various equivalent modifications are possible within the spirit and scope of the disclosure, as those skilled in the relevant art will recognize and appreciate.

As indicated, these modifications may be made in light of the foregoing description of illustrated embodiments and are to be included within the spirit and scope of the disclosure. Thus, while particular embodiments are described, a latitude of modification, various changes and substitutions are intended in the foregoing disclosures, and it will be appreciated that in some instances some features of embodiments disclosed herein will be employed without a corresponding use of other features, and features described with respect to one embodiment may be combined with features of other embodiments without departing from the scope and spirit of the disclosure as set forth herein.

The description also includes the following numbered clauses:
1. A method for providing power to a chip mounted on a host board, the method comprising:
   mounting a chip on a first side of a host board;
   mounting a daughter board on a second side of the host board opposite the first side of the board, wherein a plurality of connective electrical components are connected between the daughter board and the host board at locations which are proximal to a location of the chip;
   providing power from a power converter to the daughter board; and
   conveying the power through the daughter board to the connective electrical components, and through the connective electrical components to the chip.
2. The method of clause 1, wherein the connective electrical components comprise a plurality of decoupling capacitors, the method further comprising, for each decoupling capacitor, soldering each end cap of the decoupling capacitor to corresponding electrical connections of the daughter board and the host board to form a corresponding electrical path between the daughter board and the host board.
3. The method of clause 1, wherein the connective electrical components comprise a plurality of coaxial conductors, the method comprising, for each coaxial conductor, securing the coaxial conductor between the daughter board and the host board, wherein a first conductive ring of the coaxial conductor forms a first electrical path between the daughter board and the host board and a second conductive ring of the coaxial conductor forms a second electrical path between the daughter board and the host board.
4. The method of any of clauses 1 to 3, wherein the power converter is mounted on the daughter board.
5. The method of any of clauses 1 to 3, wherein the power converter is mounted on the host board, the method further comprising conveying the power from the host board to the daughter board prior to conveying the power through the daughter board to the connective electrical components.
6. The method of any of clauses 1 to 5, wherein the daughter board has one or more power processing components mounted thereon, the method further comprising processing, by the one or more power processing components, the power received from the power converter prior to conveying the power through the connective electrical components to the chip.

## Claims

1. An apparatus comprising:
a host board having a chip mounted on a first side of the board;
a daughter board mounted on a second side of the host board opposite the first side of the board, wherein a plurality of connective electrical components are connected between the daughter board and the host board at locations which are proximal to a location of the chip; and
a power converter which provides power to the daughter board;
wherein the daughter board delivers power to the chip via the connective electrical components.

2. The apparatus of claim 1, wherein the connective electrical components comprise a plurality of capacitors.

3. The apparatus of claim 2, wherein each capacitor comprises an insulator between two conductive end caps, wherein for each capacitor, each end cap is soldered to a corresponding conductive trace on the daughter board and a corresponding conductive trace on the host board.

4. The apparatus of claim 1, wherein the connective electrical components comprise a plurality of coaxial conductors.

5. The apparatus of claim 4, wherein each coaxial conductor comprises an outer conductive ring and an inner conductive ring which are separated by a first insulating ring.

6. The apparatus of claim 4 or claim 5, wherein each coaxial conductor further comprises a structural post.

7. The apparatus of claim 6, wherein the structural post is electrically conductive and wherein the structural post further comprises a second insulating ring positioned between the structural post and the inner conductive ring.

8. The apparatus of claim 7, further comprising a heat sink and a backing plate, wherein the heat sink is positioned in contact with a side of the chip opposite the host board and the backing plate is positioned on a side of the daughter board opposite the host board, and wherein the structural posts secure the heat sink to the backing plate and thereby hold the heat sink in contact with the chip.

9. The apparatus of any of claims 5 to 8, further comprising, for each coaxial conductor, corresponding sets of contact pads on the host board and the daughter board, wherein each of the sets of contact pads is electrically connected to an electrical component of either the host board or the daughter board, wherein each of the contact pads in the first set is positioned to contact either the outer conductive ring or the inner conductive ring of the coaxial conductor when the coaxial conductor is mounted between the daughter board and the host board.

10. The apparatus of any preceding claim, further comprising a plurality of spacers that are positioned between the daughter board and the host board, the spacers maintaining structural spacing between the daughter board and the host board.

11. The apparatus of claim 10, wherein the plurality of spacers comprise conductive material, and wherein each of the plurality of spacers carries current between the daughter board and the host board.

12. The apparatus of any preceding claim, wherein the power converter is mounted on the daughter board.

13. The apparatus of any of claims 1-11, wherein the power converter is mounted on the host board at a position which is in a peripheral region of the host board, and wherein power from the power converter is routed from the peripheral region of the host board to the daughter board and then routed from the daughter board to the host board via the connective electrical components proximal to the location of the chip.

14. The apparatus of any preceding claim, wherein the daughter board has power processing components mounted on two opposing sides of the daughter board.

15. A method for providing power to a chip mounted on a host board, the method comprising:
mounting a chip on a first side of a host board;
mounting a daughter board on a second side of the host board opposite the first side of the board, wherein a plurality of connective electrical components are connected between the daughter board and the host board at locations which are proximal to a location of the chip;
providing power from a power converter to the daughter board; and
conveying the power through the daughter board to the connective electrical components, and through the connective electrical components to the chip.
